# EUROPEAN PATENT APPLICATION

(11) **EP 1 906 253 A1**
(43) Date of publication of application: **02.04.2008**
(21) Application number: 06020465.8
(22) Date of filing: 28.09.2006
(51) Int. Cl.: G03F 7/20

(54) **Projection objective of a microlithographic projection exposure apparatus**

(71) Applicant: Carl Zeiss SMT AG, 73447 Oberkochen (DE)
(72) Inventor: Reisinger, Gerd, 73447 Oberkochen (DE); Hartung, Frank, 73614 Schrondorf (DE); Dinger, Alexander, 73432 Aalen (DE)
(74) Representative: Schwanhäusser, Gernot

(57) **Abstract**

A projection objective of a microlithographic exposure apparatus comprises a refractive optical element (L5; L6) which is made of a solid material being transparent for an operating wavelength of the apparatus (10). The optical element (L5; L6) has a surface (44; 44') through which projection light propagates during an exposure operation of the apparatus (10). The objective (20) further comprises a liquid (34) which is in direct contact to said surface (44; 44') during the exposure operation. The surface (44; 44') has a substantially plane or substantially rotationally symmetric shape and comprises a wavefront correction area (46; 46') where the surface shape deviates by more than 1 µm from a perfectly plane or rotationally symmetric design shape as it has been determined during a design process.

## Description

### BACKGROUND OF THE INVENTION

### 1. Field of the Invention

The present invention relates to microlithographic projection exposure apparatuses such as are used for the production of microstructured components. The invention relates, in particular, to projection exposure apparatuses with an immersion projection objective.

### 2. Description of Related Art

Microlithography (also called photolithography or simply lithography) is a technology for the fabrication of integrated circuits, liquid crystal displays and other microstructured devices. More particularly, the process of microlithography, in conjunction with the process of etching, is used to pattern features in thin film stacks that have been formed on a substrate, for example a silicon wafer. At each layer of the fabrication, the wafer is first coated with a photoresist which is a material that is sensitive to radiation, such as deep ultraviolet (DUV) light. Next, the wafer with the photoresist on top is exposed to projection light through a mask in a projection exposure apparatus. The mask contains a circuit pattern to be projected onto the photoresist. After exposure the photoresist is developed to produce an image corresponding to the circuit pattern contained in the mask. Then an etch process transfers the circuit pattern into the thin film stacks on the wafer. Finally, the photoresist is removed. Repetition of this process with different masks results in a multilayered microstructured component.

A projection exposure apparatus typically includes an illumination system, a mask stage for a aligning the mask, a projection objective and a wafer alignment stage for aligning the wafer coated with the photoresist. The illumination system illuminates an illumination field on the mask that may have the shape of an elongated rectangular slit.

In current projection exposure apparatus a distinction can be made between two different types of apparatus. In one type each target portion on the wafer is irradiated by exposing the entire mask pattern onto the target portion in one go; such an apparatus is commonly referred to as a wafer stepper. In the other type of apparatus, which is commonly referred to as a step-and-scan apparatus or scanner, each target portion is irradiated by progressively scanning the mask pattern under the projection beam in a given reference direction while synchronously scanning the substrate table parallel or anti-parallel to this direction. The ratio of the velocity of the wafer and the velocity of the mask is equal to the magnification of the projection objective, which is usually smaller than 1, for example 1:4.

It is to be understood that the term "mask" (or reticle) is to be interpreted broadly as a patterning means. Commonly used masks contain transmissive or reflective patterns and may be of the binary, alternating phase-shift, attenuated phase-shift or various hybrid mask type, for example. However, there are also active masks, e.g. masks realized as a programmable mirror array. An example of such a device is a matrix-addressable surface having a viscoelastic control layer and a reflective surface. More information on such mirror arrays can be gleaned, for example, from US 5,296,891 and US 5,523,193. Also programmable LCD arrays may be used as active masks, as is described in US 5,229,872. For the sake of simplicity, the rest of this text may specifically relate to apparatus comprising a mask and a mask table; however, the general principles discussed in such apparatus should be seen in the broader context of the patterning means as hereabove set forth.

One of the most prominent objects in the development of projection exposure apparatuses is to be able to lithographically define structures having increasingly smaller dimensions on the wafer. Small structures result in high integration densities. This generally has a favorable effect on the performance of the lithographically produced components.

The size of the definable structures depends, above all, on the resolution of the projection objective that is being used. Since the resolution of the projection objectives is inversely proportional to the wavelength of the projection light, one approach for improving the resolution is to use projection light having shorter and shorter wavelengths. The shortest wavelengths that are used at present are within the deep ultraviolet spectral region (DUV) and amount to 193 nm or occasionally even 157 nm.

Another approach for improving the resolution is to introduce an immersion liquid having a high refractive index into an immersion interspace that is formed between a final lens of the projection objective on the image side and the photoresist or another light-sensitive layer to be exposed. Projection objectives that are designed for immersion mode, and that are therefore also designated as immersion lenses, may attain numerical apertures (NA) of more than 1, for example 1.3 or 1.4. However, the immersion not only enables high numerical apertures, and thereby an improved resolution, but also increases the depth of focus. The greater the depth of focus, the less demanding are the requirements as far as an exact positioning of the wafer in the image plane of the projection objective is concerned.

WO 2004/107048 A2 discloses a projection objective of a microlithographic projection exposure apparatus which comprises a plane-parallel terminating element having an optical surface that is immersed in an immersion liquid. This surface is provided with aspherical surface deformations in the range of a few nanometers for correcting wavefront deformations.

US 2005/0219707 A discloses a projection objective of a microlithographic projection exposure apparatus in which an interspace formed between a pair of adjacent lenses is filled with a liquid. At least one surface which is in contact to the liquid is provided with an aspherical surface deformation in the range of a few nanometers. The effect of this surface deformation may be altered by changing the refractive index of the liquid, for example by varying its temperature.

In both publications surface deformations in the order of a few nanometers are described for correcting wavefront deformations that result in image errors of the projection objective.

### SUMMARY OF THE INVENTION

It is an object of the present invention to provide a projection objective of a microlithographic projection exposure apparatus which ensures superior imaging qualities with lower production costs.

This object is achieved by a projection objective comprising a refractive optical element which is made of a solid material being transparent for an operating wavelength of the apparatus. The optical element has a surface through which projection light propagates during an exposure operation of the apparatus. The objective further comprises a liquid which is in direct contact to said surface during the exposure operation. The surface has a substantially plane or substantially rotationally symmetric shape and comprises a wavefront correction area where the surface shape deviates by more than 1 µm, preferably more than 50 µm, from a perfectly plane or rotationally symmetric design shape as it has been determined during a design process.

It has been found that, due to the smaller refractive index difference at the surface of the refractive optical element which is in contact to the liquid, comparatively large surface deformations are required for obtaining a desired corrective effect on the optical wavefront. This reduces the accuracy which is required for producing the surface deformations, and thus considerably relaxes the technological demands. More specifically, it is not necessary to remove just a few layers of atoms from an optical surface, as it has been the case hitherto. Therefore much less accurate and therefore less expensive methods may be applied for producing surface deformations that correct optical wavefront deformations.

### BRIEF DESCRIPTION OF THE DRAWINGS

Various features and advantages of the present invention may be more readily understood with reference to the following detailed description taken in conjunction with the accompanying drawing in which:
- FIG. 1: shows a microlithographic projection exposure apparatus according to a first embodiment in greatly simplified meridional section;
- FIG. 2: is an enlarged detail from the image-side end of a projection objective which is part of the projection exposure apparatus shown in FIG. 1;
- FIG. 3: is an enlarged detail from the image-side end of a projection objective according to another embodiment.

### DESCRIPTION OF PREFERRED EMBODIMENTS

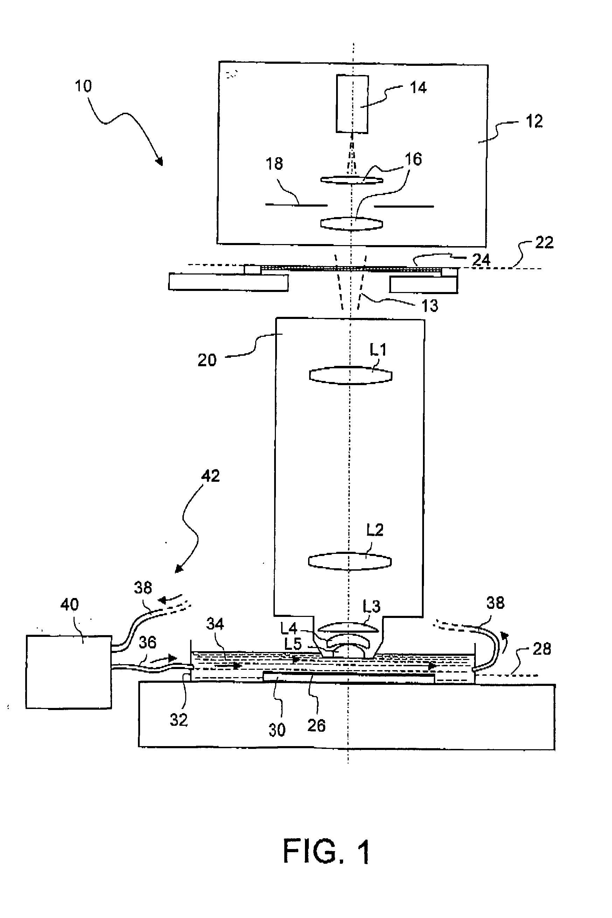

FIG. 1 shows a microlithographic projection exposure apparatus according to a first embodiment in greatly simplified meridional section. The projection exposure apparatus, which is denoted in its entirety by 10, comprises an illumination system 12 for generating projection light 13. The illumination system includes a light source 14, illuminating optics denoted by 16 and a diaphragm 18. In the embodiment shown it is assumed that the projection light has a wavelength of 193 nm. However, other wavelengths such as 157 nm or 248 nm are contemplated as well.

The projection exposure apparatus 10 further comprises a projection objective 20 which contains a plurality of lenses. For the sake of clarity only five lenses are schematically shown and denoted by L1 to L5. The lenses L1 to L5 may be fabricated from synthetic quartz glass or from calcium-fluoride (CaF₂) crystals, for example. These materials are still sufficiently transparent even at a wavelength of 193 nm. The projection objective 20 images a mask 24 arranged in an object plane 22 of the projection objective 20 onto a light-sensitive layer 26. The light-sensitive layer 26 is arranged in an image plane 28 of the projection objective 20 and applied on a support 30, for example a silicon wafer.

In this embodiment the support 30 is fastened to the bottom of a container 32 which is capable of being displaced parallel to the image plane 28 with the aid of a displacing device (not shown) similar to a conventional wafer stage. The container 32 is filled with an immersion liquid 34, for example water, such that during operation of the projection exposure apparatus 10 the last optical element of the projection objective 20 is immersed in the immersion liquid 34. In this embodiment the last optical element is the relatively thick plano-concave lens L5. The material of the last lens L5 and the liquid 34 are selected such that the difference between the refractive indices Δn = |nₗₑₙₛ - n_{liquid}| is less than 0.1, and preferably less than 0.01. This ensures that projection light traversing the immersed plane surface of the last lens L5 is refracted only to a very limited extent.

No pairings of solid and liquid substances are yet known which are suitable as a lens material and as an immersion liquid, respectively, and which have exactly the same refractive index. There are, however, material pairings with a difference of the refractive indices Δn that is in the indicated range. An example of a suitable material for the last lens L5 is lithium fluoride (LiF). At a wavelength of 193 nm, LiF has a refractive index of 1.4432, whereas the refractive index of light water is 1.4366. Thus An = 0.0064 which is well below 0.01.

Via a supply line 36 and a drainage line 38 the container 32 is connected to a conditioning unit 40 in which a circulating pump, a filter for cleaning the immersion liquid 34 and a temperature-control device are contained. Since such devices are known as such in the art, they are not shown in FIG. 1 for the sake of simplicity. The conditioning unit 40, the supply line 36, the drainage line 38 and also the container 32 form in their entirety an immersion device denoted by 42 in which the immersion liquid 34 is circulated, cleaned and kept at constant temperature. The immersion device 42 increases the depth of focus and makes it possible to use a projection objective having a numerical aperture NA > 1.

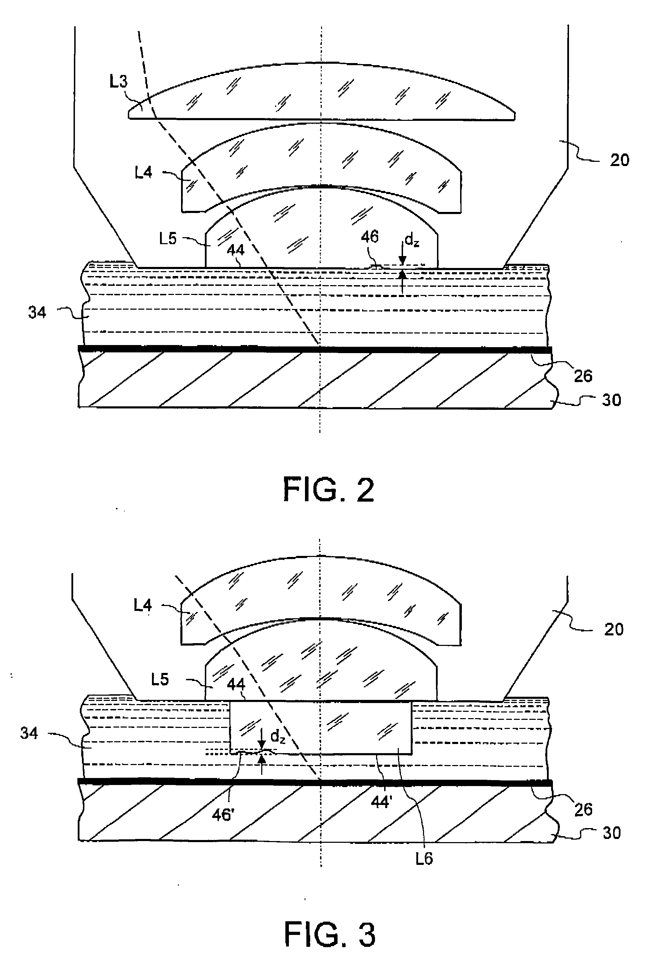

FIG. 2 is an enlarged detail of FIG. 1 showing the image-side end of the projection objective 20.

In the enlarged representation it can be discerned that the last lens L5 is provided, on its otherwise plane image-side surface 44, with a small depression 46 having a maximum depth along the direction of a surface normal that is denoted by d_{z}. In FIG. 2 the size of the depression 46 is significantly exaggerated for the sake of clarity. In reality, the maximum depth d_{z} of the depression 46 is in the order of a few micrometers, but at least 1 µm which is about five times the wavelength of the projection light. This will be explained in more detail further below.

The depression 46 is provided for correcting rotationally asymmetric image errors. The correction of rotationally symmetric image errors is comparatively straightforward. An image error is referred to as being rotationally symmetric if the distribution of a certain imaging error is rotationally symmetric in the image plane, or if the wavefront deformation in the exit pupil is rotationally symmetric. The term wavefront deformation refers to the deviation of a wave from the ideal aberration-free wave. Rotationally symmetric image errors can be corrected, for example, at least partially by moving individual optical elements along the optical axis.

Correction of those image errors which are not rotationally symmetric is more difficult. Such image errors occur, for example, because lenses and other optical elements heat up rotationally asymmetrically. One image error of this type is astigmatism, which may also be encountered for the field point lying on the optical axis. Causes of rotationally asymmetric image errors may, for example, be a rotationally asymmetric, in particular slit-shaped, illumination of the mask, as is typically encountered in projection exposure apparatus of the scanner type. The slit-shaped illumination field causes a non-uniform heating of the optical elements, and this induces image errors which often have a twofold symmetry.

However, image errors with other symmetries, for example threefold or fivefold, or image errors characterized by completely asymmetric wavefront deformations are frequently observed in projection objectives. Completely asymmetric image errors are often caused by material defects which are statistically distributed over the optical elements contained in the projection objective.

Particularly for correcting image errors characterized by completely asymmetric wavefront deformations it is known to rework certain optical surfaces in order to produce very small aspherical and (usually) rotationally asymmetric deformations. US 6,268,903 B1 describes in more detail how such aspherical deformations are determined for correcting a given wavefront deformation. The surface deformations computed in this way are usually applied to the optical surface under consideration by locally removing material. In principle, however, it is also possible to apply additional material to the surface.

In order to be able to determine the required surface deformation, it is necessary to determine the image error, i.e. the wavefront deformation, beforehand. Usually, this is done by carrying out measurements of the image quality, for example using interferometric measurement devices arranged in the image plane 28. However, it may be also contemplated to determine the image errors by simulation. This is because certain causes of image errors are known before the projection objective 20 is assembled. For example, rotationally asymmetric heating of lenses and other optical elements, or effects of birefringent lens materials, may be taken into account when the image quality of the projection objective 20 is computationally determined.

During the process of determining an appropriate surface deformation that corrects or at least reduces the rotationally asymmetric image error determined by measurement of simulation, it is necessary to take into account the refractive index ratio at the optical interface where the surface deformation shall be produced. Usually these optical interfaces are between solid lenses and a surrounding gas. This results in refractive index differences of usually more than 0.4. As a result, surface deformations in the order of a few nanometers are necessary for correcting optical wavefronts deformations that remain, after application of other corrective methods, as residual imaging errors. Usually the residual wavefront deformations of projection objectives are, in terms of wavefront deformations, in the order of less than one wavelength.

Producing surface deformations of a few nanometers involves technically sophisticated processes which are prone to error and are therefore quite expensive. A deviation of 1 nanometer of the machined surface from the desired surface deformation results, depending on the refractive indices of the materials, in an error of the corrected wavefront in the order of 0.5 nm.

Another problem, which is frequently occurred during the process of aspherically deforming optical correction surfaces, is related to anti-reflection (AR) coatings. Usually such AR coatings are indispensable because the coating prevents untolerable light losses at the optical surface. At present the AR coatings have to be applied to the optical surface after the correcting surface deformation has been produced. However, coating the deformed optical element is a very difficult process, because only low coating temperatures are allowed if the lens shall be kept in its lens mount, or the lens has to be separated from its mount and be remounted again after the coating process which results in high adjustment expenses. Apart from that the lens as such may be deformed in an undesired manner during the coating process. In document WO 2004/057378 A1 it has been proposed to deform not the lens material as such, but its AR coating so that no additional coating process is required. However, this approach puts some restrictions to the design of the AR coating, and furthermore the maximum size of the deformation is limited.

During the usual correction process, the optical errors are first measured, and then an optical element is determined whose surface(s) shall be deformed. This optical element is removed from the projection objective and remounted again after the corrective deformations have been produced. This process involves the adjustment of the optical element during the remounting process. If the optical element is slightly compressed, bended, tilted or discentered, the image quality may deteriorate instead of becoming better. Also if the respective original optical element is not deformed, but replaced by another optical element having the desired corrective deformation, even more image errors may be produced. This is because the new optical element is (apart from the surface deformation) usually not completely identical with the original optical element, and thus additional adjustment and correction work may be necessary.

Using an optical surface that is immersed in an immersion liquid solves many of the problems mentioned above. Since no substantial refractive index difference occurs at the optical surface, it is less sensible to misadjustments. Apart from that, it is not necessary to apply an AR coating to an optical surface that is immersed into an immersion liquid. A simple protective layer may be applied to the deformed surface, but the process for applying such a single layer is much simpler than the deposition of a multi-layer AR coating.

One of the most prominent advantages, however, is that larger deformations are required for obtaining the desired correction of the optical wavefront. With a refractive index difference of 0.1 and a wavelength of 193 nm, a surface deformation as large as 1 µm results in a comparatively small wavefront deformation of about one half of the wavelength. Here the term "large" refers to the dimension perpendicular to the surface. The production of a larger surface deformations is, from a technological point of view, much simpler than the removal of a few layers of atoms in the conventional process. This is mainly due to the fact that there are considerably less stringent requirements on the process accuracy since deviations by a few nanometers will have no significant optical effect due to the small refractive index difference.

For that reason the maximum dimension of the depression 46 in a direction perpendicular to the surface 44 exceeds 1 µm and preferably 10 µm. If the last immersed optical surface is designed as a curved surface, as is described in WO 2005/106589 A1, for example, the term "perpendicular" relates to the rotationally symmetric design shape of the lens as at it has been determined during the original design process.

FIG. 3 shows another embodiment in which the last optical element of the projection objective 20 is an additional terminating element L6 having the shape of a plane-parallel plate. The terminating element L6 is attached with its object-side plane surface to the image-side surface 44 of the lens L5. During immersion operation the image-side surface 44' of the terminating element L6 is immersed in the immersion liquid 34. Since the terminating element L6 is in fact attached from the outside to the last but one lens L5, it may be exchanged more easily than the other lenses L1 to L5 contained in the projection objective 20. Some of the problems mentioned above, in particular those that are caused by the removal and the remounting of the optical element, are thus substantially relieved. Due to its plane-parallel shape, the terminating element L6 has no refractive power and therefore has only comparatively little effect on the imaging properties. This additionally eases the constraints with respect to the positioning accuracy.

Therefore this terminating element L6 is ideally suited for being provided with a surface depression 46' having a maximum dimension d_{z} for which the same considerations apply as for the surface depression 46 of the embodiment shown in FIG. 2.

The above description of the preferred embodiments has been given by way of example. From the disclosure given, those skilled in the art will not only understand the present invention and its attendant advantages, but will also find apparent various changes and modifications to the structures and methods disclosed. The applicant seeks, therefore, to cover all such changes and modifications as fall within the spirit and scope of the invention, as defined by the appended claims, and equivalents thereof.

## Claims

1. A projection objective of a microlithographic projection exposure apparatus (10), comprising:
a) a refractive optical element (L5; L6) which
- is made of a solid material being transparent for an operating wavelength of the apparatus (10) and
- has a surface (44; 44') through which projection light (13) propagates during an exposure operation of the apparatus,
b) a liquid (34) which is in direct contact to the surface (44; 44') during the exposure operation,
wherein the surface (44; 44')
c) has a substantially plane or substantially rotationally symmetric shape and
d) comprises a wavefront correction area (46; 46') where the surface shape deviates by more than 1 µm from a perfectly plane or rotationally symmetric design shape as it has been determined during a design process.

2. The objective of claim 1, wherein the surface shape of the wavefront correction area (46; 46') deviates by more than 50 µm from the perfectly plane or rotationally symmetric shape.

3. The objective of claim 1 or 2, wherein the difference between the refractive indices of the material and the liquid is less than 0.1.

4. The objective of claim 3, wherein the difference between the refractive indices of the material and the liquid is less than 0.01.

5. The objective of any of the preceding claims, wherein the refractive optical element is a substantially plane-parallel plate (L6) or a lens (L5) having at least one curved surface.

6. The objective of any of the preceding claims, wherein the refractive optical element (L5; L6) is the last optical element of the projection objective on its image side.

7. A refractive optical element for an immersion projection objective (20) of a microlithographic projection exposure apparatus (10), which
a) is made of a solid material being transparent for an operating wavelength of the apparatus (10) and
b) has a surface (44; 44') through which projection light (13) propagates during an exposure operation of the apparatus (10), wherein the surface
- has a substantially plane or substantially rotationally symmetric shape and
- comprises a wavefront correction area (46; 46') where the surface (44; 44') shape deviates by more than 1 µm from a perfectly plane or rotationally symmetric design shape as it has been determined during a design process.

8. A method for correcting an image error of a projection objective for a microlithographic projection exposure apparatus (10), comprising the following steps:
a) determining a wavefront deformation causing the image error of the projection objective (20);
b) determining a wavefront correction area (46; 46') of an optical surface (44; 44') of a refractive optical element (L5; L6) contained in the projection objective (20) such that the wavefront deformation determined in step a) is reduced, wherein the surface shape deviates within the wavefront correction area (46; 46') by more than 1 µm from a perfectly plane or rotationally symmetric design shape as it has been determined during an original design process of the projection objective (20);
c) producing a correcting refractive optical element (L5; L6) having the wavefront correction area determined in step b);
d) mounting the correcting refractive optical element (L5; L6) produced in step c) into the projection objective (20).

9. The method of claim 8, wherein the wavefront deformation in step a) is measured.

10. The method of claim 9, wherein the correcting refractive optical element (L5; L6) replaces an optical element which has been mounted in the projection objective (20) when the wavefront deformation is measured.

11. The method of claim 10, wherein the correcting refractive optical element (L5; L6) is produced in step c) by removing material from the refractive optical element which has been mounted in the projection objective (20) when the wavefront deformation is measured.
